# EUROPÄISCHE PATENTSCHRIFT

(11) **EP 0 838 984 B1**
(45) Veröffentlichungstag und Bekanntmachung des Hinweises auf die Patenterteilung: **05.02.2003**
(21) Anmeldenummer: 97116933.9
(22) Anmeldetag: 30.09.1997
(51) Int. Cl.: H05K 7/14, F16B 35/04

(54) **Baugruppenträger**
Electronic rack
Baie électronique

(30) Priorität: 25.10.1996 DE 19644419
(43) Veröffentlichungstag der Anmeldung: 29.04.1998
(73) Patentinhaber: Schroff GmbH, D-75334 Straubenhardt (DE)
(72) Erfinder: Günther, Hans-Ulrich, 76327 Pfinztal (DE); Mazura, Paul, 76302 Karlsbad (DE); Haag, Volker, 75323 Bad Wildbad (DE); Pfeifer, Klaus, 76199 Karlsruhe (DE); Thalau, Klaus-Michael, 76316 Malsch (DE); Joist, Michael, 76571 Gaggenau (DE); Weiss, Udo, 75334 Straubenhardt (DE)
(74) Vertreter: Durm, Klaus, Dr.-Ing.

(56) Entgegenhaltungen:
- EP-A- 0 038 652
- DE-A- 3 133 638
- DE-U- 9 012 844

## Beschreibung

Die Erfindung betrifft einen Baugruppenträger für auf Führungsschienen einschiebbare Leiterplatten, mit zwei parallelen Seitenwänden und wenigstens vier parallel verlaufenden Modulschienen, auf welchen die Führungsschienen befestigbar sind. Die Modulschienen weisen an ihren Stirnseiten jeweils ein zylindrisches Loch zur Aufnahme einer Befestigungsschraube auf, während die Seitenwände mit Befestigungslöchern für die Befestigungsschrauben und mit Vorsprüngen zum Anlegen der Modulschienen versehen sind (vgl. z.B. DE-U-9012844.3).

Es versteht sich , daß insbesondere für Anwendungen in der Elektronik, bei denen vielpolige Steckverbindungen mit kleinsten Abmessungen eingesetzt werden, eine genaue Führung der Leiterplatten in den Führungsschienen eines Baugruppenträgers unerläßlich ist. Die exakte Ausrichtung der Führungsschienen hängt jedoch maßgeblich von der exakten, insbesondere vertikalen Positionierung der Modulschienen an den Seitenwänden des Baugruppenträgers ab.

Es ist bekannt, die Seitenwände eines Baugruppenträgers mit nach innen weisenden Vorsprüngen zu versehen, die in einem bestimmten Abstand ober- oder unterhalb der Befestigungslöcher für die Modulschienen angeordnet sind. Diese Vorsprünge fungieren als Positionierhilfen beim Befestigen der Modulschienen an den Seitenwänden, indem die Modulschienen auf die Vorsprünge angelegt und dann die Befestigungsschrauben durch die Befestigungslöcher der Seitenwände in die hierfür vorgesehenen zylindrischen Löcher der Modulschienen eingeführt werden.

Aus fertigungstechnischen Gründen weisen die Befestigungslöcher in den Seitenwänden einen gegenüber dem Außendurchmesser der Befestigungsschrauben deutlich größeren Innendurchmesser auf, so daß ein Verschieben der Modulschienen senkrecht zur Schraubenachse auch mit im Befestigungsloch sitzender Befestigungsschraube möglich ist.

Dadurch ergeben sich jedoch Probleme, denn es ist dem handwerklichen Geschick des jeweiligen Monteurs überlassen, ob die Modulschienen nach dem Festziehen der Befestigungsschrauben tatsächlich an den jeweiligen Vorsprüngen anliegen. Darüber hinaus neigen die Modulschienen beim Festziehen der Befestigungsschrauben dazu, sich mitzudrehen.

Im Ergebnis können nach dem beschriebenen Stand der Technik die für verschiedene Anwendungen erforderlichen, engen Montagetoleranzen für die Positionierung der Führungsschienen nicht oder nur mit unverhältnismäßig großem handwerklichen Aufwand erreicht werden.

Um eine zwangsgeführte Anlage der Modulschienen auf die Vorsprünge beim Festziehen der Befestigungsschrauben zu erreichen, wurde außerdem vorgeschlagen, die Befestigungslöcher in den Seitenwänden außenseitig mit einer Ansenkung zu versehen und als Befestigungsschrauben Senkkopfschrauben zu verwenden.

Diese Vorgehensweise bringt jedoch ebenfalls Probleme mit sich, denn auch hier ist der Innendurchmesser der Befestigungslöcher größer als der Außendurchmesser des Gewindeschaftes der Befestigungsschrauben, so daß der Senkkopf einer Befestigungsschraube bei auf den Vorsprung angelegter Modulschiene nicht allseitig in der Senkung des Befestigungslochs sitzt, sondern lediglich in deren oberen Abschnitt. Der Kraftschluß zwischen den Befestigungsschrauben und der Seitenwand ist daher unbefriedigend und läßt befürchten, daß über längere Zeiträume Ermüdungserscheinungen auftreten. Darüber hinaus ist das Ansenken der Befestigungslöcher in der Seitenwand fertigungstechnisch sehr aufwendig.

Der Erfindung liegt daher die Aufgabe zugrunde, einen Baugruppenträger vorzuschlagen, der eine neuartige Schraubverbindung zwischen den Modulträgern und den Seitenteilen enthält. Diese Schraubverbindung soll die Einhaltung von engen Montagetoleranzen auf einfache Weise ermöglichen, wobei sie dennoch hochbelastbar und langzeitstabil sein soll.

Diese Aufgabe ist durch einen Baugruppenträger mit den im Anspruch 1 genannten Merkmalen gelöst.

Vorteilhafte Weiterbildungen der Erfindung ergeben sich aus den Ansprüchen 2 bis 5.

Erfindungsgemäß ist ein bekannter Baugruppenträger der eingangs genannten Art also mit speziellen Befestigungsschrauben ausgerüstet, die aus einem Schraubenkopf mit ebener Auflagefläche und einem im wesentlichen zylindrischen Gewindeschaft bestehen. Zwischen dem Schraubenkopf und dem Gewindeschaft ist ein konisches Zwischenstück angeordnet, welches sich vom Schraubenkopf zum Gewindeschaft hin verjüngt. Weiterhin ist die maßliche Anordnung der zylindrischen Löcher in den Stirnseiten der Modulschienen, der Befestigungslöcher in den Seitenwänden sowie der Vorsprünge so dimensioniert, daß beim Festziehen der Befestigungsschrauben deren Zwischenstück gegen die Außenkante der Befestigungslöcher aufläuft und infolge der daraus resultierenden Gegenkraft die Modulschiene zwangsweise gegen den Vorsprung bewegt.

Der endgültige Kraftschluß zwischen einer Befestigungsschraube und der zugehörigen Seitenwand ergibt sich dadurch, daß die Auflagefläche des Schraubenkopfs beim Festziehen der Befestigungsschraube auf die Außenseite der Seitenwand zu sitzen kommt. Der Kraftschluß wirkt also allseitig um das Befestigungsloch. Die Erfindung vereint daher die Vorteile einer Schraubverbindung durch Zylinderkopfschrauben mit denen einer Schraubverbindung durch Senkkopfschrauben, wobei die jeweiligen Nachteile vermieden werden. Darüberhinaus verbleibt eine Kraftkomponente, die die Modulschiene permanent an den Vorsprung preßt, so daß auch ein Verdrehen der Modulschiene beim endgültigen Festziehen der Befestigungsschraube nicht zu befürchten ist.

Besondere Vorteile ergeben sich, wenn die Materialien der Befestigungschrauben und der Seitenwände derart aufeinander abgestimmt sind, daß sich beim Eindrehen der Befestigungsschrauben - dann, wenn die Modulschiene bereits auf dem zugehörigen Vorsprung anliegt und das in den Befestigungsschrauben integrierte Zwischenstück gegen die Außenkante des Befestigungsloches aufläuft - eine irreversible Verformung der Außenkante des Befestigungslochs einstellt. Denn zunächst wird beim Eindrehen wegen des auflaufenden konischen Zwischenstücks die Befestigungsschraube, und mit ihr die Modulschiene, zum Vorsprung hin bewegt. Diese Bewegung endet, wenn die Modulschiene auf dem Vorsprung anliegt. Durch weiteres Eindrehen der Befestigungsschraube verformt sich dann die Außenkante des Befestigungslochs, so daß die Kontaktfläche zwischen der Befestigungsschraube und der Innenseite des Befestigungslochs vergrößert wird. Hierbei wirkt eine Kraftkomponente in Richtung Vorsprung auf die Modulschiene. Wenn sich schließlich die Auflagefläche des Schraubenkopfs auf die Außenseite der Seitenwand auflegt, nimmt das Einschraubdrehmoment sprunghaft zu und der Kraftschluß zwischen der Modulschiene und der Seitenwand wird hergestellt, wobei die Kraftübertragungsfläche nicht nur die verformte Innenseite des Befestigungslochs, sondern vor allem die das Befestigungsloch umgebende Kontaktfläche zwischen der Seitenwand und dem Schraubenkopf ist.

Zur elektrischen Kontaktierung der Modulschienen mit den Seitenwänden des Baugruppenträgers ist es zweckmäßig, wenn die Befestigungsschrauben an der Auflagefläche ihres Schraubenkopfs eine Anzahl von Kontaktkrallen aufweisen, welche die Oxidschicht der Seitenwände beim Festziehen der Schrauben durchdringen. Diese Kontaktkrallen sind vorzugsweise als widerhakenförmig angeordnete Dreieckspyramiden ausgebildet.

Die erfindungsgemäße Wirkung der speziell ausgebildeten Befestigungsschrauben wird vorzugsweise mit einem konischen Zwischenstück erzielt, dessen Ansenkungswinkel ca. 60 Winkelgrade beträgt.

Anhand der beigefügten Zeichnungen wird im folgenden ein Ausführungsbeispiel der Erfindung näher beschrieben. Es zeigen:
- Figur 1: eine schematische, perspektivische Darstellung eines Baugruppenträgers;
- Figur 2a: schematisch die Befestigung einer Modulschiene an einer Seitenwand nach dem Stand der Technik;
- Figur 2b: schematisch die Befestigung einer Modulschiene an einer Seitenwand nach einem anderen Stand der Technik;
- Figur 2c: schematisch die erfindungsgemäße Befestigung einer Modulschiene an einer Seitenwand;
- Figur 3: eine erfindungsgemäß ausgebildete Befestigungsschraube;
- Figur 4: eine Ansicht in Richtung A gemäß Figur 3.

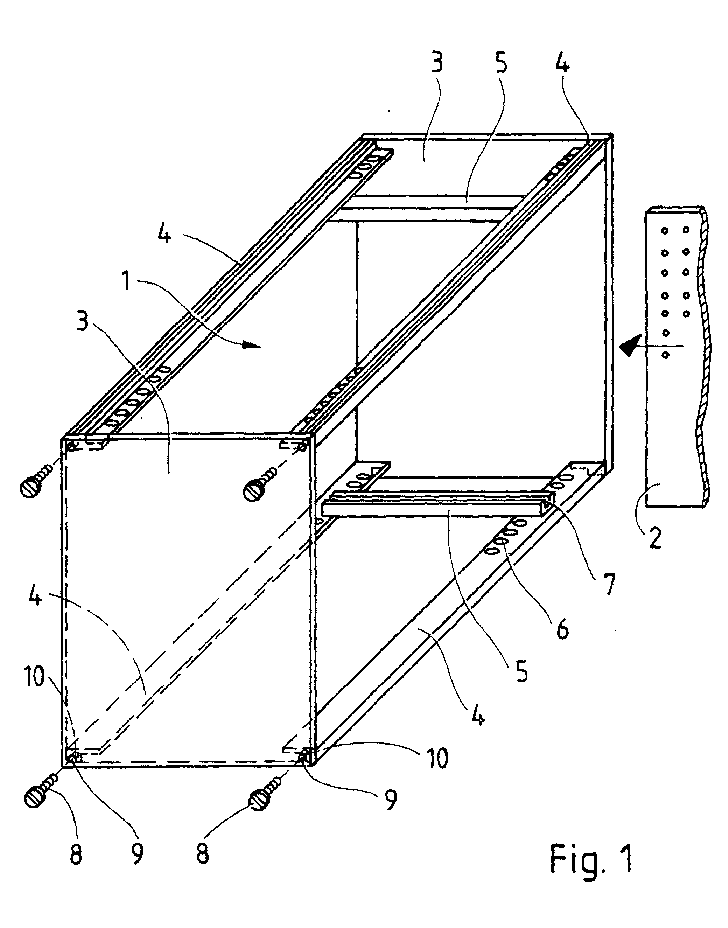

Der in Figur 1 dargestellte Baugruppenträger 1 ist zur Aufnahme einer größeren Zahl von einschiebbaren Leiterplatten 2 vorgesehen, welche mit elektrischen und elektronischen Bauelementen (nicht dargestellt) bestückt sind. Der Baugruppenträger 1 ist im wesentlichen aus zwei rechteckigen, parallelen Seitenwänden 3 sowie vier parallel verlaufenden Modulschienen 4 zusammengesetzt.

Die vier aus gezogenem Aluminium hergestellten Modulschienen 4 verbinden die beiden Seitenwände 3. Die beiden unteren Modulschienen 4 sowie die beiden oberen Modulschienen 4 tragen jeweils eine obere bzw. untere Führungsschiene 5. Diese Führungsschienen 5 sind mittels federnder Klemmelemente quer zu den Modulschienen 4 befestigt. Die Klemmelemente sind in Langlöcher 6 eingeschnappt, mit welchen die Modulschienen 4 äquidistant versehen sind. Die aus Kunststoff gepreßten Führungsschienen 5 weisen je eine Führungsnut 7 zur Aufnahme der Leiterplatten 2 auf.

Die Modulschienen 4 werden mittels Befestigungsschrauben 8 an den Seitenwänden 3 befestigt. Die Befestigungsschrauben 8 durchgreifen entsprechende Befestigungslöcher 9 in den Seitenwänden 3 und werden in zylindrische Löcher 10 in den Modulschienen 4 eingeschraubt.

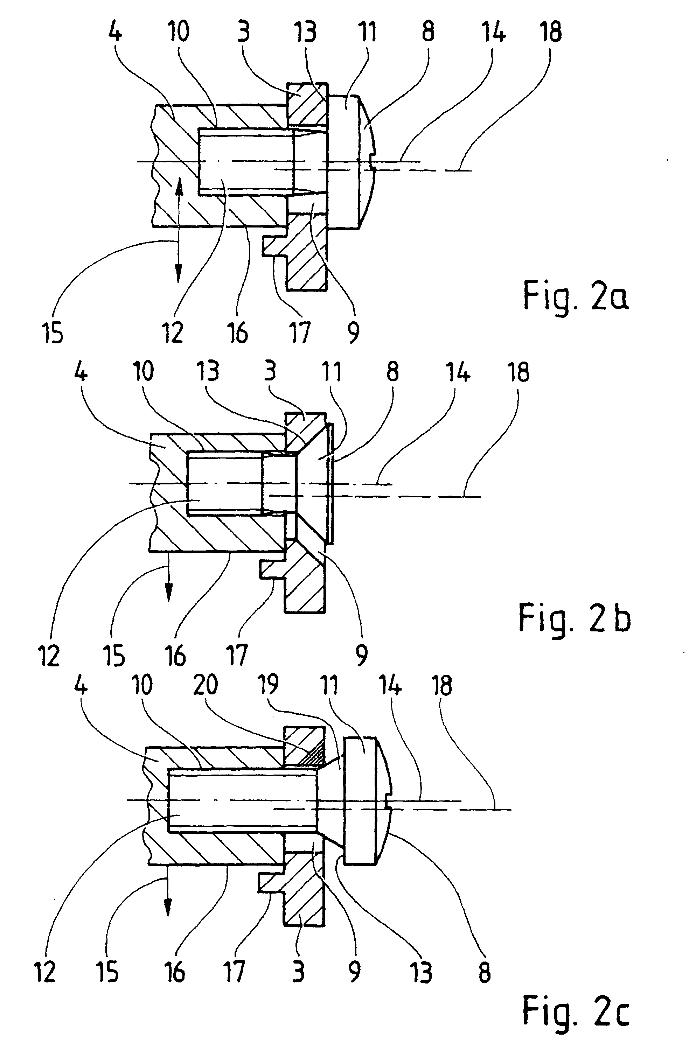

Figur 2 zeigt die Verbindung der Modulschienen 4 mit den Seitenwänden 3 mittels der Befestigungsschrauben 8 im Detail, wobei die Figuren 2a und 2b dem Stand der Technik entnommen sind und die Figur 2c die erfindungsgemäße Befestigungstechnik zeigt.

Figur 2a entspricht dem allgemein üblichen Stand der Technik, bei dem eine Befestigungsschraube 8, deren Schraubenkopf 11 zylindrisch ausgebildet ist, durch ein Befestigungsloch 9 in der Seitenwand 3 hindurch in ein zylindrisches Loch 10 in der Modulschiene 4 eingeschraubt ist. Der zylindrische Gewindeschaft 12 der Befestigungsschraube 8 setzt sich bis zur Auflagefläche 13 des Schraubenkopfes 11 zylindrisch fort. Der Außendurchmesser des Gewindeschafts 12 ist aus fertigungstechnischen Gründen kleiner als der Innendurchmesser des Befestigungslochs 9, so daß die Ist-Achse 14 der Befestigungsschraube 8 insbesondere in den Richtungen, die durch den mit dem Bezugszeichen 15 bezeichneten Pfeil angedeutet ist, verschoben werden kann. Um eine insbesondere vertikal exakte Positionierung der Modulschiene 4 an der Seitenwand 3 zu erreichen, muß die Unterkante 16 der Modulschiene 4 auf dem dafür vorgesehenen Vorsprung 17 aufliegen. Der Monteur des Baugruppenträgers 1 muß daher beim Festdrehen der Befestigungsschraube 8 darauf achten, daß die Ist-Achse 14 mit der Soll-Achse 18 zur Deckung kommt. Gleichzeitig darf sich die Modulschiene 4 durch das auf die Befestigungsschraube 8 aufgebrachte Drehmoment nicht mitdrehen.

Figur 2b zeigt eine im Stand der Technik vereinzelt anzutreffende Ausbildung der Befestigung einer Modulschiene 4 an einer Seitenwand 3. Die Befestigungsschraube 8 ist hier als Senkkopfschraube ausgebildet, deren zylindrischer Gewindeschaft 12 wiederum durch ein Befestigungsloch 9 in der Seitenwand 3 hindurch in ein zylindrisches Loch 10 in der Modulschiene 4 eingeschraubt wird. Zur Aufnahme des Schraubenkopfs 11 der Befestigungsschraube 8 muß das Befestigungsloch 9 mit einer Ansenkung versehen sein. Auch hier muß die Unterkante 16 der Modulschiene 4 auf dem Vorsprung 17 der Seitenwand 3 aufliegen, um eine exakte Ausrichtung der Modulschiene 4 zu gewährleisten. Nach dem hier dargestellten Stand der Technik ergibt sich allerdings beim Eindrehen der Befestigungsschraube 8 durch das Zusammenwirken des Schraubenkopfes 11 mit der Ansenkung des Befestigungslochs 9 eine Zwangsführung der Modulschiene 4, die eine zwangsweise Bewegung in Richtung des Pfeiles 15 bis zur Auflage auf den Vorsprung 17 ausführt. Der Monteur des Baugruppenträgers 1 muß daher kein spezielles Augenmerk darauf richten, daß die Ist-Achse 14 mit der Soll-Achse 18 zur Deckung kommt.

Wie Figur 2b jedoch deutlich zeigt, ist durch das Verwenden einer Senkkopfschraube und durch die Ansenkung des Befestigungslochs 9 die Kraftübertragungsfläche zwischen der Modulschiene 4 und der Seitenwand 3 auf den oberen Teil der Auflagefläche 13 des Schraubenkopfs 11 beschränkt. In den meisten Fällen wird die Auflagefläche 13 die Ansenkung des Befestigungslochs 9 nur in einem kleinen Winkelbereich ihres Umfangs berühren. Dies mindert die Stabilität und die Belastbarkeit der dargestellten Verbindung erheblich.

Figur 2c zeigt die erfindungsgemäße Verbindung zwischen einer Modulschiene 4 und einer Seitenwand 3 mittels einer speziell ausgebildeten Befestigungsschraube 8: Die Befestigungsschraube 8 besteht aus einem zylindrischen Schraubenkopf 11 und einem daran anschließenden, sich zum zylindrischen Gewindeschaft 12 hin konisch verjüngenden Zwischenstück 19. Das Befestigungsloch 9 in der Seitenwand 3 ist zylindrisch ausgebildet, wobei dessen Innendurchmesser wiederum größer ist als der Außendurchmesser des Gewindeschaftes 12.

Die Befestigungsschraube 8 wird zunächst entlang der Ist-Achse 14 in das zylindrische Loch 10 der Modulschiene 4 ohne größeren Widerstand eingedreht. Sobald das Zwischenstück 19 gegen die Innenkante des Befestigungslochs 9 aufläuft, ergibt sich eine Zwangsbewegung der Modulschiene 4 in Richtung des Pfeils 15. Wenn die Unterkante 16 der Modulschiene 4 auf dem Vorsprung 17 aufliegt und die Ist-Achse 14 mit der Soll-Achse 18 übereinstimmt, nimmt das Einschraubdrehmoment für die Befestigungsschraube 8 sprunghaft zu. Die Auflagefläche 13 des Schraubenkopfs 11 liegt zu diesem Moment jedoch noch nicht auf der Außenseite der Seitenwand 3 auf: die Befestigungsschraube 8 läßt sich noch ein Stück weiter drehen. Bei dieser Drehbewegung wird die Innenkante des Befestigungslochs 9 im Verformungsbereich 20 irreversibel verformt, wodurch die Verbindungsfläche zwischen der Innenseite des Befestigungslochs 9 und der Außenseite des Zwischenstücks 19 vergrößert wird. Dieser Vorgang setzt sich fort, bis die Auflagefläche 13 des Schraubenkopfs 11 allseitig auf dem rund um das Befestigungsloch 9 befindlichen Bereich der Seitenwand 3 aufliegt und den dauerhaften Kraftschluß zwischen der Modulschiene 4 und der Seitenwand 3 herstellt. Auch nach dem endgültigen Festziehen der Befestigungsschraube 8 verbleibt eine in Richtung des Pfeils 15 wirkende Kraftkomponente auf die Modulschiene 4, so daß die exakte Ausrichtung der Modulschiene 4 auch bei schwerer Belastung, wie z.B. einem hohen Gewicht der eingeschobenen Leiterplatten 2 und/oder Vibrationen und Rüttelbewegungen, gewährleistet bleibt.

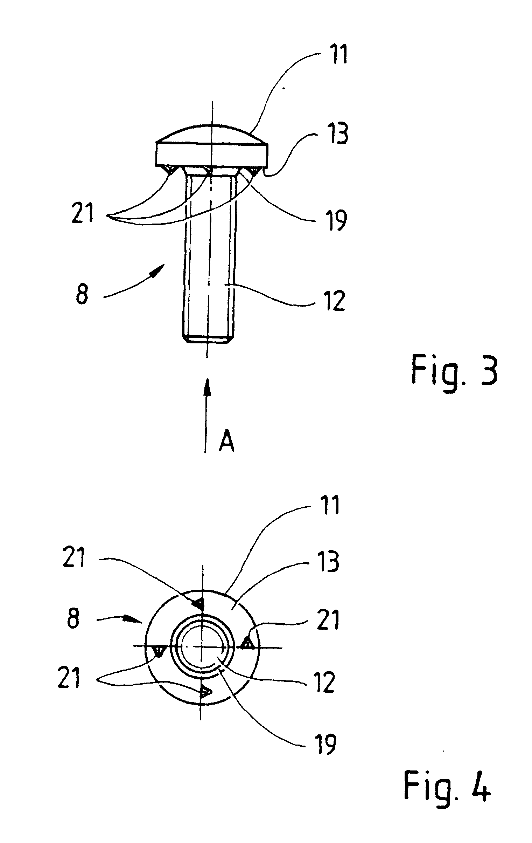

Figur 3 zeigt eine erfindungsgemäß ausgebildete Befestigungsschraube 8 maßstäblich. Der halbrunde, in seiner Grundform zylindrisch ausgebildete Schraubenkopf 11 ist über das konisch ausgebildete Zwischenstück 19 mit dem zylindrischen Gewindeschaft 12 verbunden. Die Auflagefläche 13 des Schraubenkopfs 11 trägt als Dreieckspyramide ausgebildete, widerhakenförmig angeordnete Kontaktkrallen 21, um die Kontaktierung der Befestigungsschraube 8 mit einer Seitenwand 3 auch durch eine Oxidschicht hindurch gewährleisten zu können.

Figur 4 zeigt die Befestigungsschraube 8 aus Figur 3 in einer Ansicht aus Richtung A. Neben dem Gewindeschaft 12, dem Zwischenstück 19 und der Auflagefläche 13 des Schraubenkopfs 11 ist deutlich erkennbar, daß insgesamt vier Kontaktkrallen 21, jeweils um 90 Grad versetzt, auf der Auflagefläche 13 angeordnet sind. Die widerhakenförmige Ausbildung der Kontaktkrallen 21 hat schließlich den vorteilhaften Nebeneffekt, daß sich die Befestigungsschraube 8 bei Vibrationen und Rüttelbewegungen nicht so leicht löst.

### Zusammenstellung der Bezugszeichen

- 1: Baugruppenträger
- 2: Leiterplatte
- 3: Seitenwände
- 4: Modulschienen
- 5: Führungsschienen
- 6: Langlöcher
- 7: Führungsnut
- 8: Befestigungsschrauben
- 9: Befestigungslöcher (in 3)
- 10: Löcher (in 4)
- 11: Schraubenkopf
- 12: Gewindeschaft
- 13: Auflagefläche (von 11)
- 14: Ist-Achse (von 8)
- 15: Pfeil
- 16: Unterkante (von 4)
- 17: Vorsprung
- 18: Soll-Achse (von 8)
- 19: Zwischenstück (von 8)
- 20: Verformungsbereich (von 3)
- 21: Kontaktkrallen

## Patentansprüche

1. Baugruppenträger für auf Führungsschienen einschiebbare Leiterplatten, mit zwei parallelen Seitenwänden (3) und wenigstens vier parallel verlaufenden Modulschienen (4), auf welchen die Führungsschienen (5) befestigbar sind, wobei die Modulschienen (4) an ihren Stirnseiten jeweils ein zylindrisches Loch (10) zur Aufnahme einer Befestigungsschraube (8) aufweisen, während die Seitenwande (3) mit zylindrischen Befestigungslöchern (9) für die Befestigungsschrauben (8) und mit Vorsprüngen (17) zum Anlegen der Modulschienen (4) versehen sind, **dadurch gekennzeichnet , daß** die Befestigungsschrauben (8) aus einem Schraubenkopf (11) mit ebener Auflagefläche (13), einem im wesentlichen zylindrischen Gewindeschaft (12) sowie einem zwischen dem Schraubenkopf (11) und dem Gewindeschaft (12) angeordneten, sich konisch zum Gewindeschaft (12) hin verjüngenden Zwischenstuck (19) bestehen, und daß die zylindrischen Löcher (10) in den Modulschienen (4) sowie die Befestigungslöcher (9) und die Vorsprünge (17) an den Seitenwänden (3) jeweils derart angeordnet sind, daß das Zwischenstück (19) beim Festziehen der Befestigungsschraube (8) gegen die Außenkante des Befestigungslochs (9) aufläuft und dadurch die entsprechende Modulschiene (4) gegen den zugehörigen Vorsprung (17) drückt.

2. Baugruppenträger nach Anspruch 1, **dadurch gekennzeichnet, daß** die Befestigungsschrauben (8) und die Seitenwände (3) so beschaffen sind, daß sich beim Festziehen einer Befestigungsschraube (8) aufgrund deren Zwischenstücks (19) eine irreversible Verformung der Außenkante des zugehörigen Befestigungslochs (9) ergibt.

3. Baugruppenträger nach einem der Ansprüche 1 oder 2, **dadurch gekennzeichnet, daß** die Auflageflächen (13) der Schraubenköpfe (11) je eine Anzahl von Kontaktkrallen (21) zum Kontaktieren der Befestigungsschrauben (8) mit den Seitenwänden (3) aufweisen.

4. Baugruppenträger nach Anspruch 3, **dadurch gekennzeichnet, daß** die Kontaktkrallen (21) als widerhakenförmig angeordnete Dreieckspyramiden ausgebildet sind.

5. Baugruppenträger nach einem der Ansprüche 1 bis 4, **dadurch gekennzeichnet, daß** die Zwischenstücke (19) der Befestigungsschrauben (8) einen Ansenkungswinkel von ca. 60 Winkelgraden aufweisen.

## Claims

1. Rack for circuit boards that can be inserted on guide rails with two parallel side walls (3) and at least four module rails (4) extending in parallel to which the guide rails (5) may be secured, wherein at the respective front side of the module rails a cylindrical hole (10) for receiving a securing screw (8) is provided, while the side walls (3) are provided with cylindrical securing holes (9) for the securing screw (8) and with projections (7) against which the module rails (4) are to bear, **characterised in that** the securing screws (8) consist of a screw head (11) with a planar bearing surface (13), essentially cylindrical threaded shaft (12) and an intermediate piece (19) between the screw head (11) and the threaded shaft (12) which tapers conically towards the cylinder shaft (12), and **in that** the cylindrical holes (10) in the module rails (4) as well as the securing holes (9) and the projection (17) at the side walls (3) are respectively so arranged that on tightening the securing screw (8) the intermediate piece (9) abuts against the outer edge of the securing hole (9) and thereby presses the corresponding module rail (4) against the associated projection (17).

2. A rack according to claim 1 **characterised in that** the securing screws (8) and the side walls (3) are so constructed that on tightening a securing screw (8), due its intermediate piece (19), an irreversible deformation of the outer edge of the associated securing hole (9) results.

3. A rack according to one of claims 1 or 2, **characterised in that** the bearing surfaces (13) of the screw heads (11) each have a number of contact claws (21) for contacting the securing screws (8) with the side walls (3).

4. A rack according to claim 3 **characterised in that** the contact claws (21) are formed as barb-shaped triangular pyramids.

5. A rack according to one of claims 1 to 4 **characterised in that** the intermediate members (19) of the securing screws (9) have a taper angle of about 60 degrees.

## Revendications

1. Baie pour modules électroniques pour recevoir des cartes imprimées enfichables sur des rails de guidage, comprenant deux parois latérales parallèles (3) et au moins quatre rails modulaires parallèles (4), sur lesquels peuvent être fixés les rails de guidage (5), les rails modulaires (4) présentant chacun sur son côté frontal un trou cylindrique (10) pour le logement d'une vis de fixation (8), tandis que les parois latérales (3) sont munies de trous de fixation cylindriques (9) pour les vis de fixation (8) et de saillies (17) pour la pose des rails modulaires (4), **caractérisée en ce que** les vis de fixation (8) se composent d'une tête de vis (11) ayant une surface d'appui plane (13), d'une tige filetée (12) essentiellement cylindrique, ainsi que d'une partie intercalaire (19) disposée entre la tête de vis (11) et la tige filetée (12) et se rétrécissant en cône en direction de la tige filetée (12), et que les trous cylindriques (10) dans les rails modulaires (4), ainsi que les trous de fixation (9) et les saillies (17) sur les parois latérales (3), sont disposés à chaque fois de telle sorte que la partie intercalaire (19) passe contre le bord extérieur du trou de fixation (9) lors du serrage de la vis de fixation (8) et que le rail modulaire correspondant (4) est de ce fait pressé contre la saillie correspondante (17).

2. Baie pour modules électroniques suivant la revendication 1, **caractérisée en ce que** les vis de fixation (8) et les parois latérales (3) sont constituées de telle sorte qu'il se produit une déformation irréversible du bord extérieur du trou de fixation correspondant (9) lors du serrage d'une vis de fixation (8), en raison de la partie intercalaire (19).

3. Baie pour modules électroniques suivant l'une des revendications 1 et 2, **caractérisée en ce que** les surfaces d'appui (13) des têtes de vis (11) présentent chacune un certain nombre de griffes de contact (21) pour la mise en contact des vis de fixation (8) avec les parois latérales (3).

4. Baie pour modules électroniques suivant la revendication 3, **caractérisée en ce que** les griffes de contact (21) sont réalisées sous forme de pyramides triangulaires disposées en forme de barbillons.

5. Baie pour modules électroniques suivant l'une des revendications 1 à 4, **caractérisée en ce que** les pièces intercalaires (19) des vis de fixation (8) présentent un angle de chanfrein d'environ 60°.
